# FASCICULE DE BREVET EUROPEEN

(11) **EP 2 779 223 B1**
(45) Date de publication et mention de la délivrance du brevet: **23.11.2016**
(21) Numéro de dépôt: 14354005.2
(22) Date de dépôt: 12.03.2014
(51) Int. Cl.: H01L 21/762

(54) **Procédé de réalisation d'un substrat muni d'une protection de bord**
Herstellungsverfahren eines Substrats, das mit einem Kantenschutz ausgestattet ist
Method for producing a substrate provided with edge protection

(30) Priorité: 15.03.2013 FR 1300609
(43) Date de publication de la demande: 17.09.2014
(73) Titulaire: Commissariat à l'Energie Atomique et aux Energies Alternatives, 75015 Paris (FR); STMicroelectronics SA, F-92120 Montrouge (FR)
(72) Inventeur: Previtali, Bernard, F-38100 Grenoble (FR); Arvet, Christian, F-38190 Bernin (FR)
(74) Mandataire: Hecké, Gérard

(56) Documents cités:
- US-A1- 2007 042 600
- US-A1- 2012 094 502
- US-A1- 2013 029 475

## Description

### Domaine technique de l'invention

L'invention est relative aux substrats semi-conducteurs destinés à être utilisés dans le domaine électronique, optique ou optoélectronique.

### État de la technique

L'augmentation incessante des performances des circuits intégrés, se traduit nécessairement par une amélioration continue des étapes technologiques de fabrication. Par ailleurs, la technologie microélectronique actuelle, est basée sur l'utilisation de substrats, communément appelés plaquettes (ou « wafer » en terminologie anglaise), en matériau semi-conducteur. La réalisation de substrats de qualité, dépourvus de défauts cristallographiques et topographiques, constitue la première brique importante pour réaliser des dispositifs microélectroniques plus performants.

Le procédé Czochralski (Cz), à titre d'exemple, est actuellement bien optimisé et permet de fabriquer à grande échelle des substrats ayant une bonne qualité cristallographique. De ce fait, les efforts fournis pour améliorer la qualité des substrats de départ, d'un point de vue technique, se focalisent de plus en plus sur les aspects mécaniques de fabrication. Notamment, la topographie du substrat et la forme de ses bords, qui ont été identifiées comme des paramètres pouvant impacter le rendement et la qualité du procédé de fabrication des circuits intégrés.

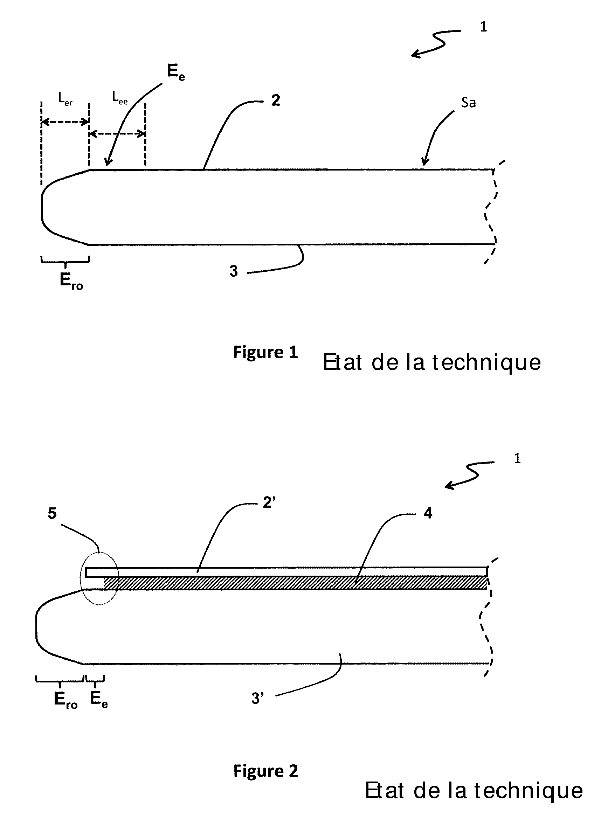

La figure 1 illustre la forme géométrique d'un substrat 1 usuel en matériau semi-conducteur, utilisé dans le domaine de la microélectronique. Le substrat 1 comporte des faces avant et arrière 2 et 3 planes. Les substrats ont généralement la forme d'un disque dont le diamètre peut atteindre 300 mm selon les normes actuelles de fabrication des circuits intégrés à grande échelle.

La face avant 2, comporte une surface active Sa sur laquelle différentes étapes technologiques seront réalisées par la suite, notamment pour former des dispositifs à l'échelle micro ou nano métrique, ou encore pour réaliser un collage moléculaire avec un autre substrat. La face avant 2 comporte également une surface périphérique d'exclusion Eₑ (également appelée « Edge Exlusion » en terminologie anglo-saxonne). La largeur de la surface d'exclusion Lₑₑ est de l'ordre de 2 à 3 mm.

La surface du substrat 1 comporte en outre une surface latérale Eᵣₒ, munie d'un chanfrein ou d'« une tombée de bord », usuellement appelée en terminologie anglo-saxonne « Edge roll-off ». La surface latérale Eᵣₒ, relie entre elles les faces avant et arrière, 2 et 3. La largeur de la surface latérale Lₑᵣ est généralement de l'ordre de 0,5 mm. La surface latérale Eᵣₒ a pour but de faciliter la manipulation du substrat et d'éviter les bris de bords qui pourraient se produire pour des bords saillants.

Cependant, les bords des substrats engendrent plusieurs problèmes qui nuisent au rendement des procédés technologiques de fabrication. Par bord d'un substrat, on entend la partie du substrat formée par la surface latérale Eᵣₒ et la surface périphérique d'exclusion Eₑ. A titre d'exemple, lors de la réalisation d'un report de films par collage moléculaire, les bords des substrats massifs utilisés peuvent être responsables de l'apparition de zones de non collage, de tranchées, de piqures, etc.

La figure 2 illustre un substrat de type SOI réalisé par collage moléculaire, en utilisant par exemple un substrat usuel de la figure 1. Le substrat SOI comporte généralement un film de silicium 2' formant la face avant, séparé d'un support 3' par une couche d'oxyde 4.

Selon l'exemple illustré à la figure 2, les bords des substrats peuvent être responsables en outre, lors de la réalisation d'un substrat de type SOI, de la formation d'une ailette 5 du film de silicium 2' au niveau du bord (Eᵣₒ et Eₑ) de la plaquette.

À cause de la forme des bords de substrats classiques ou de type SOI, plusieurs problèmes de contamination et anomalies topographiques ont été constatés lors des procédés classiques de fabrication des dispositifs à l'échelle micro ou nanométrique.

Le document US 2013/029475 décrit un procédé de protection des bords de plaquettes semi-conductrices par dépôt d'une couche isolante sur les dits bords.

### Objet de l'invention

L'invention a pour objet un procédé de réalisation d'un substrat amélioré, comportant notamment un bord protégé, permettant de minimiser des anomalies topographiques dans le substrat.

On tend vers cet objet par les caractéristiques de la revendication 1

Selon une mise en oeuvre avantageuse, le premier matériau de protection est gravé en outre sur une zone périphérique de la première face adjacente à la surface latérale. Ensuite, la deuxième couche en deuxième matériau de protection est formée sur la surface latérale et sur ladite zone périphérique.

Le substrat comporte consécutivement : un support comprenant la deuxième face principale, une couche électriquement isolante, une couche en matériau semi-conducteur comprenant la première face principale. En outre, le deuxième matériau de protection recouvre la surface latérale de la couche électriquement isolante.

Par ailleurs, selon d'autres caractéristiques avantageuses et non limitatives :
- la formation de la première couche en premier matériau de protection est précédée de la formation d'une couche préliminaire en oxyde de silicium enrobant le substrat ;
- la deuxième couche de protection est en oxyde de silicium par oxydation ;
- le procédé comporte une étape de lithographie définissant la zone périphérique ;
- l'élimination du premier matériau de protection, est suivie par la réalisation d'un transistor à effet de champ sur la première face du substrat.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, en vue de coupe, un substrat semi-conducteur classique de type massif ;
- la figure 2 représente, de manière schématique, en vue de coupe, un substrat semi-conducteur classique de type SOI ;
- les figures 3 à 6 représentent, de manière schématique, en vue de coupe, des étapes de réalisation d'un substrat selon un état de la technique connu ;
- les figures 7A et 7B, représentent de manière schématique respectivement, en vue de coupe et en vue de dessus, un substrat semi-conducteur de l'état de la technique connu.
- les figures 8 à 11 représentent, de manière schématique, en vue de coupe, des étapes de réalisation d'un substrat selon l'invention
- les figures 12 et 13 représentent, de manière schématique, en vue de coupe, des substrats semi-conducteurs réalisés selon l'état de la technique.

### Description de modes de réalisation préférentiels de l'invention

Dans le domaine des substrats destinés à la fabrication de composants micro et nanoélectroniques et/ou optoélectroniques, il existe un besoin de réaliser des substrats plus résistants aux étapes technologiques, ce qui permet d'augmenter le rendement du procédé technologique de fabrication des circuits intégrés. On tend à satisfaire ce besoin en prévoyant un procédé de réalisation d'un substrat amélioré, muni d'un bord protégé.

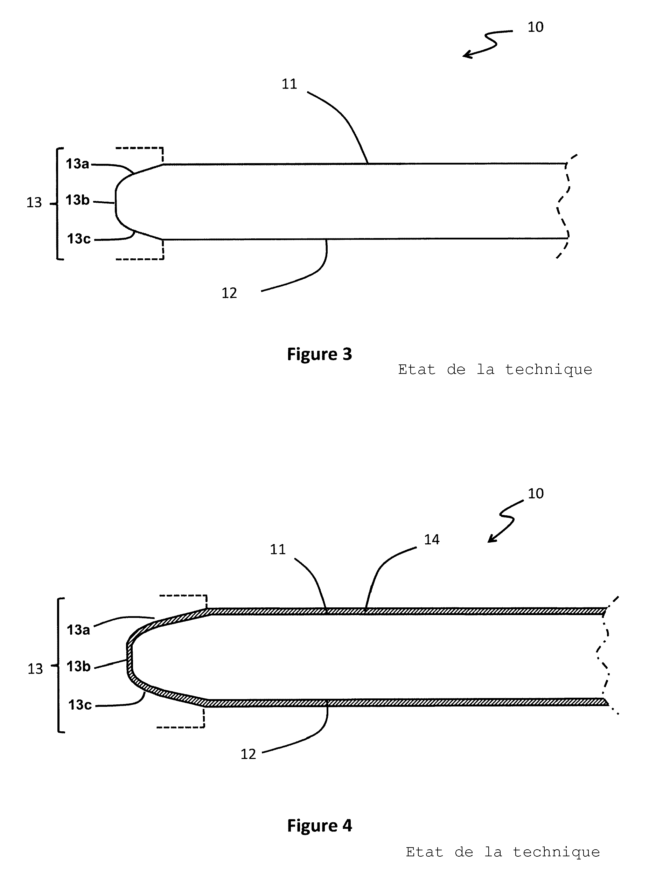

Selon un état de la technique connu et illustré à partir de la figure 3, le procédé comporte la fourniture d'un substrat 10 à base d'un matériau semi-conducteur. Le substrat 10 comporte des première 11 et deuxième 12 faces principales opposées reliées par une surface latérale 13. Les première 11 et deuxième 12 faces, et la surface latérale 13 forment ainsi la surface externe du substrat 10.

Les faces 11 et 12 sont respectivement appelées face avant et face arrière du substrat 10. Par ailleurs, la face avant d'un substrat usuel est polie et elle est destinée à subir différents traitements et procédés pour former des dispositifs micro ou nanoélectroniques sur ladite face avant. Préférentiellement, le substrat 10 est un substrat vierge dont les faces 11 et 12 sont sensiblement parallèles et planes. Par substrat vierge, on entend un substrat qui n'a pas subi d'étapes de gravure ou d'implantation ou autre, destinées à réaliser un dispositif sur sa face avant. Par surface latérale, on entend une surface reliant les faces 11 et 12 du substrat 10.

La surface latérale 13 est formée par un premier chanfrein 13a, une facette 13b et un deuxième chanfrein 13c. La facette 13b est communément appelée « bevel » en terminologie anglo-saxonne, et elle est dans un plan sensiblement perpendiculaire aux plans des faces 11 et 12. Le chanfrein 13a est une surface du substrat 10 qui constitue une tombée de bord entre la face 11 et la facette 13b. De manière analogue, le chanfrein 13c constitue une tombée de bord entre la face 12 et la facette 13b.

Dans le cas où le substrat 10 est dépourvu de facette 13b, autrement dit le substrat a un bord ayant une forme arrondie, la surface latérale 13 est alors formée uniquement par les premier 13a et deuxième 13c chanfreins. Dans ce cas, le point d'intersection entre la surface latérale 13 et un plan (non représenté) sensiblement perpendiculaire aux plans des faces 11 et 12, et tangent à la courbure de la surface latérale 13, sera équivalent à la facette 13b pour définir les surfaces 13a et 13c.

Par ailleurs, le substrat 10 peut avoir plusieurs couches superposées de matériaux semi-conducteurs différents, par exemple un support recouvert par une couche formant la face 11. La couche formant la face 11, est en matériau semi-conducteur cristallin, pouvant être monocristallin ou polycristallin. Préférentiellement, la face 11 du substrat 10 est en matériau semi-conducteur monocristallin. Le matériau semi-conducteur peut être à base de silicium, de germanium, d'alliage silicium-germanium, ou tout autre matériau semi-conducteur intrinsèque ou dopé, relaxé ou contraint.

Comme illustré à la figure 4, ce procédé connu comporte également une étape de formation d'une première couche 14 sur le substrat 10. La couche 14 est en premier matériau de protection, et elle est formée de manière à enrober le substrat 10. Autrement dit, la couche 14 recouvre toute la surface externe du substrat 10.

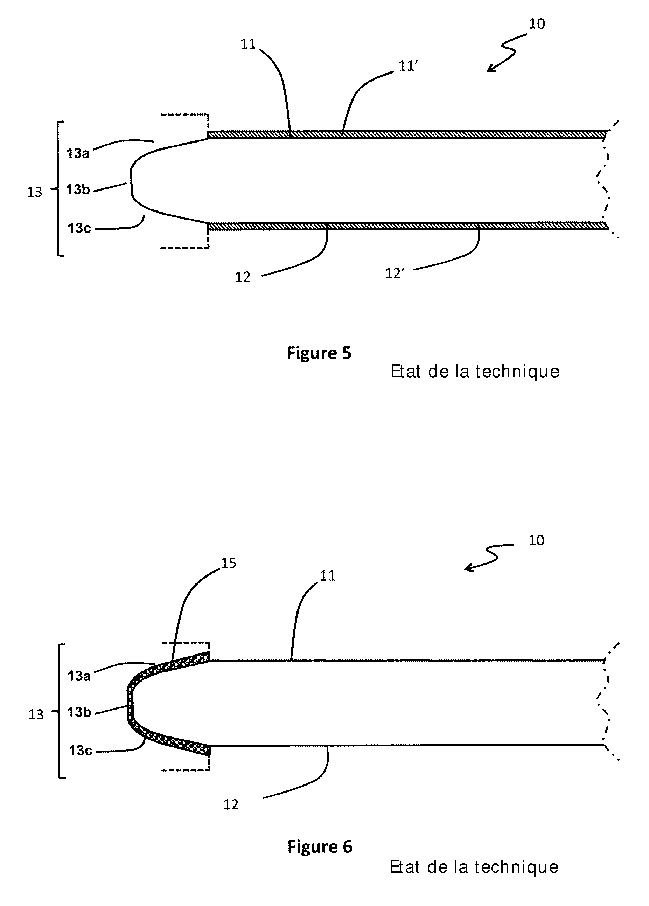

Après avoir recouvert le substrat 10 par la couche 14, une étape de gravure partielle de cette couche est alors mise en oeuvre. La figure 5 représente le substrat 10 après la gravure du premier matériau de protection sur la surface latérale 13 du substrat 10. Cette étape de gravure est réalisée de manière à laisser un motif (11' et 12') en premier matériau de protection recouvrant au moins partiellement chacune des première 11 et deuxième 12 faces. La gravure du premier matériau de protection sur la surface latérale 13 peut être réalisée par tout moyen connu et compatible avec le matériau du substrat 10 et de la couche 14. A titre d'exemple, cette gravure partielle peut être réalisée en déposant un matériau photosensible comme une résine sur le substrat 10, puis en réalisant une étape de détourage de la résine par photolithographie, destinée à enlever la résine sur la surface latérale 13. L'élimination de la résine est ensuite suivie d'une gravure du matériau de protection sur la surface latérale 13.

L'étape de gravure est réalisée par toute technique connue permettant de graver le premier matériau de protection, telle qu'une gravure sèche, humide, etc. Préférentiellement, le premier matériau de protection est gravé au moins sur la partie de la surface latérale 13 comprise entre la face 11 et la facette 13b. Avantageusement, l'étape de gravure permet de graver le premier matériau de protection sur la totalité de la surface latérale 13. L'étape de gravure est réalisée de manière qu'une portion de la couche 14 soit toujours disposée sur les faces 11 et 12 du substrat 10, après la gravure. La couche 14 est au moins partiellement gravée sur la surface latérale 13, de préférence complétement gravée.

Comme illustré à la figure 6, une deuxième couche 15 en deuxième matériau de protection est formée sur la surface latérale 13 dépourvue du premier matériau de protection. Ainsi, le deuxième matériau de protection est préférentiellement disposé sur au moins le premier chanfrein 13a afin de protéger cette région lors des futurs étapes technologiques que subira la face 11. De manière avantageuse, le deuxième matériau de protection est disposé sur la surface latérale 13 toute entière.

Avantageusement, la surface latérale 13 est dépourvue du premier matériau de protection de sorte que le deuxième matériau de protection est en contact direct avec le substrat, ici avec la couche en matériau semi-conducteur. En variante, une épaisseur réduite du premier matériau de protection existe sous le deuxième matériau de protection. Si l'épaisseur est faible, le premier matériau de protection est faiblement gravé à cause des forces de capillarité qui s'opposent à l'entrée d'un agent de gravure.

Après la formation de la couche 15 en deuxième matériau de protection, le premier matériau de protection restant est ensuite éliminé sur toute la surface du substrat 10. Ainsi, le procédé de réalisation du substrat 10, permet d'obtenir un substrat ayant la face 11 (la face avant), et la face 12 libres, ainsi que le bord 13 recouvert par le deuxième matériau de protection.

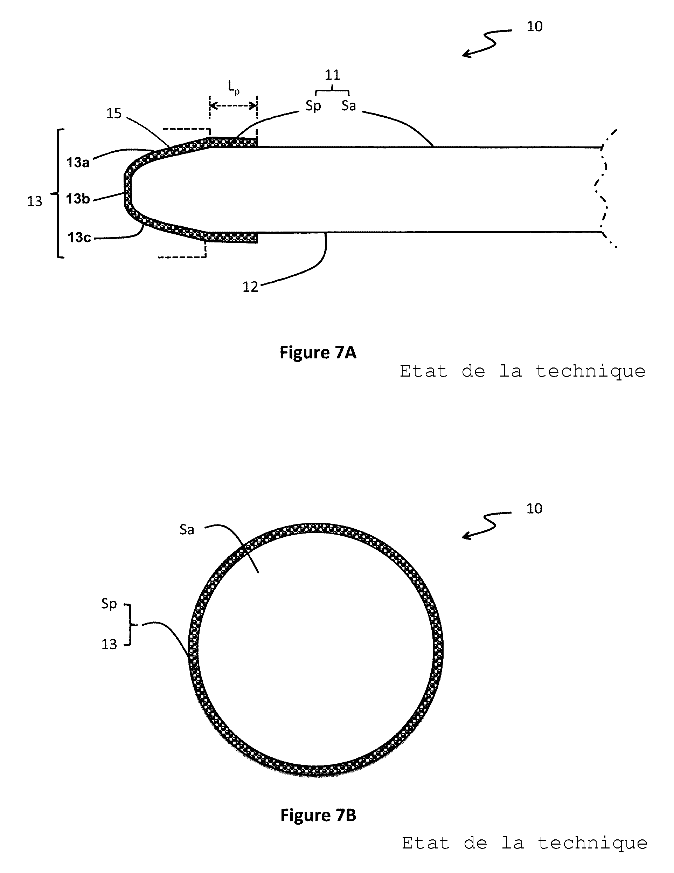

Selon un mode de mise en oeuvre avantageux illustré aux figures 7A et 7B, le premier matériau de protection est également gravé sur une zone périphérique Sp de la première face 11 adjacente à la surface latérale 13. La première face 11 comporte une surface active Sa et la zone périphérique Sp. La surface active Sa est destinée à subir, par la suite, différentes étapes technologiques, par exemple pour réaliser des dispositifs à l'échelle micro ou nano métrique. La couche 15, en deuxième matériau de protection, est ensuite formée sur la surface latérale 13 et la totalité de ladite zone périphérique Sp de la première face 11. Comme illustré à la figure 7B, la couche de protection 15 forme un anneau continu et fermé qui recouvre le bord du substrat 10, autrement dit, la surface latérale 13 du substrat et une zone périphérique Sp de la face principale 11 et préférentiellement une zone périphérique de la face 12.

Par zone périphérique, on entend une surface périphérique ayant une aire largement inférieure à l'aire totale de la face 11. La largeur Lp de la zone périphérique Sp étant de l'ordre de 2 à 3 mm, et elle correspond à la surface d'exclusion disposée sur la face avant des substrats classiques de type massif ou de type SOI (cf. figure 1).

Le procédé de réalisation du substrat 10, permet avantageusement l'obtention d'un substrat ayant, au moins une partie de son bord, recouverte par un matériau de protection. Prévoir un bord de plaque protégé, peut éviter lors d'une éventuelle étape de siliciuration, la formation de zones silliciurées parasites sur le bord de la plaque, notamment sur la facette latérale 13b du substrat 10. Ce qui permet d'éviter, de manière avantageuse, la génération d'une source de contamination métalliques et particulaires lors de l'enchaînement des étapes technologiques en utilisant les divers équipements.

Par ailleurs, la réalisation de transistors à effet de champ sur des substrats en matériau semi-conducteur peut comporter une étape d'isolation latérale de type tranchées d'isolation peu profondes STI (STI pour l'abréviation anglaise de « Shallow Trench Isolation ». Ces isolations STI comportent notamment une étape de gravure des tranchées, suivie d'une étape de dépôt d'un isolant et de planarisation chimique de l'isolant. La fourniture d'un substrat ayant un bord protégé, permet avantageusement d'éviter la formation accidentelle d'une tranchée parasite au niveau du bord de la plaque, et le dépôt par la suite de l'isolant dans cette tranchée. Par ailleurs, ce type de tranchées parasites peut être responsable de la non uniformité des épaisseurs des isolations STI. En outre, la protection du bord de la plaque permet de soigner l'uniformité des surfaces du substrat polies par CMP (CMP pour l'abréviation anglaise de « Chemical Mechanical Polishing »). En effet, lors d'une étape CMP, l'existence d'une tranchée d'isolant parasite, dont les dimensions n'ont pas été maîtrisées peut générer un problème de non uniformité du polissage : certaines zones du substrats seront polies en excès par rapport à d'autres zones.

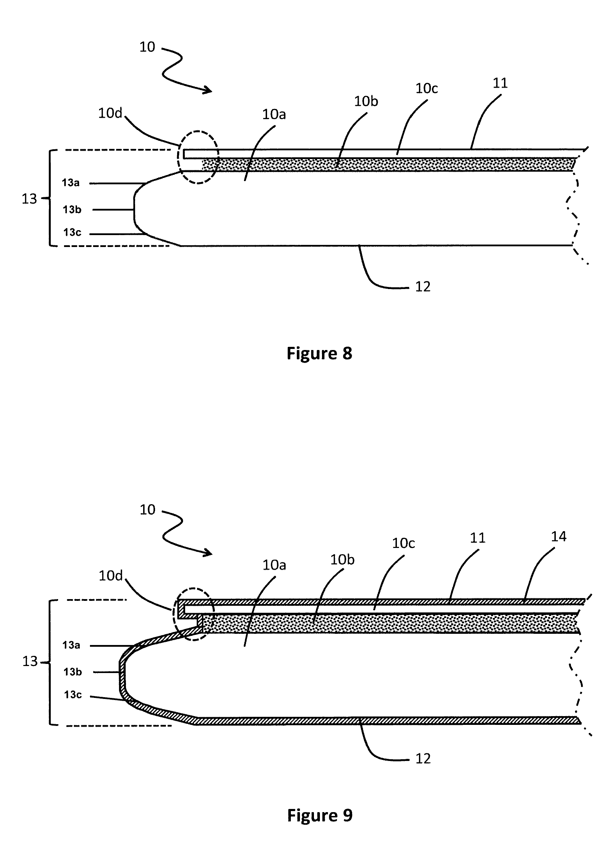

Selon l'invention le substrat 10 est un substrat de type semi-conducteur sur isolant ou SOI (SOI pour l'abréviation anglaise de « Silicon On Insulator »). Comme illustré à la figure 8, le substrat 10 de type SOI, comporte consécutivement :
- un support 10a comprenant la deuxième face principale 12 ;
- une couche électriquement isolante 10b ; et
- une couche en matériau semi-conducteur 10c comprenant la première face principale 11.

La couche électriquement isolante 10b est réalisée dans un matériau différent du matériau du support 10a. Par ailleurs, le support 10a peut comporter plusieurs couches réalisées dans des matériaux différents. Le support 10a peut être un substrat massif de silicium ou selon les applications, un autre type de matériau, par exemple un substrat de germanium, d'alliage silicium-germanium, ou tout autre matériau semi-conducteur intrinsèque ou dopé, relaxé ou contraint.

La couche électriquement isolante 10b est destinée à isoler électriquement le support 10a et la couche en matériau semi-conducteur 10c. La couche électriquement isolante 10b peut être à base d'oxyde de silicium ou de nitrure de silicium ou d'autres matériaux électriquement isolants.

La couche 10c est en matériau semi-conducteur cristallin. Le matériau semi-conducteur peut être à base de silicium, de germanium, d'alliage silicium-germanium, ou tout autre matériau semi-conducteur intrinsèque ou dopé, relaxé ou contraint. De préférence, la couche 10c est en silicium, la couche électriquement isolante 10b est en oxyde de silicium, et le support 10a est un substrat massif de silicium.

Par ailleurs, l'extrémité de la couche en matériau semi-conducteur 10c dépasse, au niveau du bord du substrat 10, l'extrémité de la couche électriquement isolante 10b, formant ainsi une ailette 10d. La longueur de l'ailette peut atteindre jusqu'à 100 µm, autrement dit une portion de la couche 10c d'une longueur d'environ 100 µm qui n'est pas disposée sur la couche 10b. La formation de ce type d'ailettes dans les substrats de type SOI, peut être attribuée aux effets de bord des substrats utilisés pour réaliser le substrat SOI. La surface latérale du substrat 10 étant définie comme la surface reliant les faces 11 et 12 sensiblement planes, parallèles et opposées, la surface latérale 13 est alors formée par (cf. figure 8) :
- la surface latérale du support 10a, autrement dit, les surfaces 13a, 13b et 13c telles qu'elles sont définies pour le substrat massif de la figure 3 ; et
- la surface latérale de l'ailette 10d, comportant la surface latérale de la couche 10c en matériau semi-conducteur et la surface latérale de la couche 10b électriquement isolante.

Dans le cas d'un substrat 10 de type SOI (cf. figure 9), la couche de protection 14 est formée de sorte à recouvrir les surfaces latérales de la couche électriquement isolante 10b et de la couche en matériau semi-conducteur 10c. Autrement dit, que ce soit pour un substrat de type SOI ou de type massif, la couche 14 est formée de manière à recouvrir toute la surface du substrat 10.

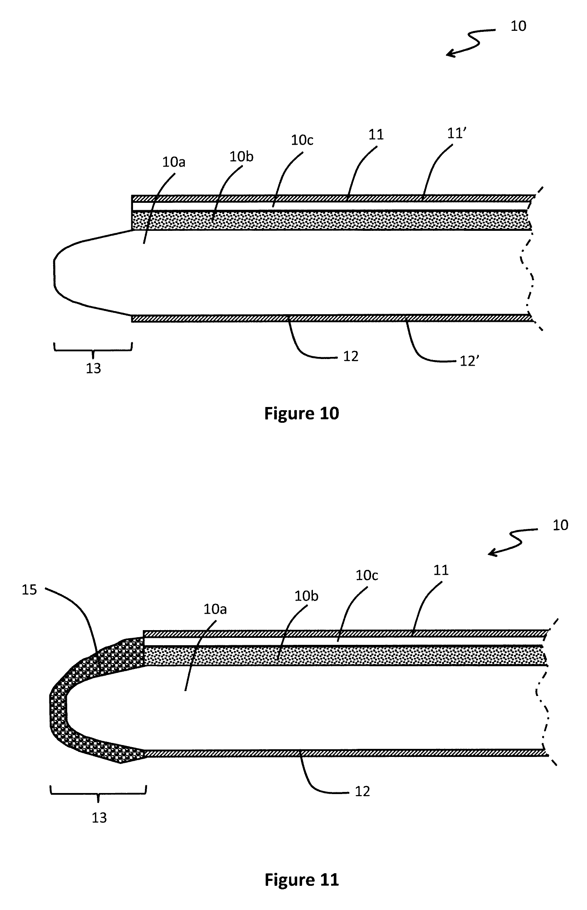

La figure 10 illustre le substrat 10 après une étape de gravure partielle de la couche 14. Le premier matériau de protection est gravé sur la surface latérale 13 du substrat 10. Cette étape de gravure est réalisée de manière à laisser un motif 11' ou 12' en premier matériau de protection recouvrant au moins partiellement chacune des première 11 et deuxième 12 faces. La gravure du premier matériau de protection sur la surface latérale 13 peut être réalisée par tout moyen compatible avec les matériaux du substrat SOI 10 et de la couche 14. La gravure peut être une gravure sèche ou humide, isotrope ou anisotrope ou une succession de plusieurs types de gravure. Par ailleurs, l'étape de gravure est réalisée de manière à laisser la première couche 14 sur les première 11 et deuxième 12 faces du substrat 10, au moins sur leurs portions centrales.

Préférentiellement, le premier matériau de protection est gravé au moins sur la partie de la surface latérale 13 comprise entre la face 11 et la facette 13b du support 10a. Autrement dit, le premier matériau de protection est gravé sur la surface de l'ailette 10d et sur la surface du premier chanfrein 13a du support 10a. Avantageusement, le premier matériau de protection est gravé sur la totalité de la surface latérale 13. De manière plus avantageuse, l'étape de gravure comporte en outre l'élimination de l'ailette 10d. Comme dans le mode de réalisation précédent, il est possible de laisser une fine couche du premier matériau de protection sur la surface latérale 13.

Après la gravure, la couche 15 en deuxième matériau de protection est formée sur la surface latérale 13 qui a été dépourvue du premier matériau de protection. Dans le cas du substrat SOI 10 (figures 8 et 9), le deuxième matériau de protection est formé de manière que la couche 15 recouvre la face latérale de la couche électriquement isolante 10b. Ainsi, le deuxième matériau de protection permet avantageusement de remplir l'évidemment formée par l'ailette 10d. De manière analogue, après la formation de la deuxième couche de protection 15, le premier matériau de protection restant est ensuite éliminé sur toute la surface du substrat SOI 10.

Le procédé de réalisation du substrat 10 selon l'invention permet avantageusement l'obtention d'un substrat muni d'un bord recouvert, au moins partiellement par un matériau de protection. Le deuxième matériau de protection permet de combler avantageusement l'évidemment créé par l'ailette 10d, et de ce fait d'éliminer une importante source de contamination particulaire que pourrait constituer l'ailette 10d lors des futures étapes technologiques. Par ailleurs, le procédé permet d'éviter une éventuelle siliciuration parasite en recouvrant la surface latérale de la couche en matériau semi-conducteur 10c. Cette surface latérale restant découverte, pourrait être siliciurée et générer ainsi une source additionnelle de contamination métallique.

En outre, le substrat amélioré 10 de type SOI permet d'éviter l'arrachement de l'ailette 10d lors d'une étape de polissage mécano-chimique (CMP). Ainsi, on évite de provoquer des rayures et des particules résiduelles qu'une ailette arrachée pourrait générer.

La formation de la couche de protection 15 sur la surface latérale disposée entre la face 11 et la facette latérale 13b, permet de manière avantageuse de réduire le dénivelé qui existe entre la première face 11 et le substrat de support. Ainsi, l'uniformité du polissage CMP pourrait être amélioré. En effet, l'absence du film SOI et de l'oxyde enterré sur la surface latérale d'un substrat SOI classique, peut engendrer un problème de non uniformité de polissage (problème usuellement appelé « dishing » en terminologie anglo-saxonne). En fait, lors de la réalisation d'une étape de CMP sur ce type de substrat, certaines zones notamment au niveau de la surface latérale peuvent être polies en excès par rapport à d'autres zones.

La réalisation de transistors à effet de champ sur des substrats en matériau semi-conducteur de type massif ou de type semi-conducteur sur isolant, comporte généralement la formation d'isolations STI. Le bord du substrat ne pouvant pas être protégé lors de l'étape de lithographie, une tranchée parasite peut alors être formée au niveau du bord du substrat 10. Lors du dépôt de l'isolant, cette tranchée parasite peut être responsable de la non uniformité des épaisseurs des isolations latérales, et de l'augmentation du problème de non uniformité de polissage lors d'une éventuelle étape de CMP.

Le procédé selon un autre mode particulier de mise en oeuvre comporte avantageusement une étape de lithographie définissant la zone périphérique Sp. Par exemple, une étape de photolithographie suivie d'une gravure définissant la zone périphérique Sp. Une couche en résine peut être étalée sur la première face 11 du substrat 10, après la formation de la première couche de protection 14. L'épaisseur de la résine est choisie de manière à être suffisante pour l'élimination du premier matériau de protection. La résine peut ensuite être détourée en utilisant par exemple une technique chimique à base de solvant, ou une technique optique en deux étapes : insolation puis développement, ou encore une combinaison des deux techniques. Lors du détourage de la résine, le substrat 10 est disposé sur un support de manière que la deuxième face 12 soit en contact avec ledit support. L'étape de détourage est réalisée de sorte à garder la surface active Sa de la première face 11 recouverte par la résine et à définir la surface périphérique Sp dans laquelle la résine est éliminée. Ainsi, la couche de résine est éliminée du bord 13 du substrat 10 et de la surface périphérique Sp.

Lors de l'étape de gravure du premier matériau de protection, la surface active Sa de la face 11 est protégée par la couche de résine, et la face 12 est protégée grâce à son contact avec ledit support du substrat. L'étape de gravure permet ainsi de définir la zone périphérique Sp et éliminer le premier matériau de protection simultanément de cette zone et du bord 13 du substrat 10. Selon la technique de gravure utilisée, le premier matériau de protection sera éliminé sur une partie ou sur la totalité du bord 13 du substrat 10.

Par ailleurs, les premier et deuxième matériaux de protection utilisés, ainsi que leurs épaisseurs, sont choisis par l'homme du métier de manière à faciliter les étapes de formation et de gravure, et à être compatibles avec le procédé technologique auquel le substrat protégé sera soumis. Avantageusement, la première couche 14 est en nitrure de silicium.

Dans le domaine de la micro ou nanotechnologie, le nitrure de silicium est un matériau largement utilisé pour ses propriétés physiques d'isolation électrique et de passivation. Le nitrure de silicium est un matériau qui constitue une barrière de diffusion efficace pour les éléments oxydants tel que l'oxygène. Ainsi, le nitrure de silicium est avantageusement utilisé comme une couche de masquage d'oxydation en micro ou nanoélectronique, ce qui permet de réaliser facilement des oxydations sélectives sur un substrat à base de silicium. Par ailleurs, les techniques de formation d'une couche en nitrure de silicium sont maîtrisées et permettent d'obtenir des dépôts avec une très bonne qualité (épaisseur, homogénéité, ...).

De préférence, le nitrure de silicium de la couche 14 est déposé par LPCVD (LPCVD pour l'abréviation anglaise de « Low Pressure Chemical Vapor Deposition »). Avantageusement, l'élimination du nitrure de silicium, après la formation de la couche 15, est réalisée par une gravure humide à base de l'acide ortho phosphorique (H₃PO₄).

De manière avantageuse, et comme illustré à la figure pour un état de la technique la formation de la première couche 14 en premier matériau de protection est précédée de la formation d'une couche préliminaire 14' en oxyde de silicium enrobant le substrat 10.

Préférentiellement, le substrat 10, notamment les faces 11 et 12, sont à base de silicium, et la formation de la couche préliminaire 14' est réalisée par oxydation. La couche préliminaire 14' peut être formée, par exemple par oxydation thermique HTO (HTO pour l'abréviation anglaise de « High Thermal Oxide »), ou à partir de tétraethylorthosilicate (oxyde TEOS), etc. Selon la technique utilisée pour former la couche préliminaire 14', une étape d'aplanissement pourrait être requise. La couche préliminaire 14' en oxyde de silicium a une épaisseur réduite, préférentiellement comprise entre 5 et 50 nm.

L'épaisseur de la couche préliminaire 14' est choisie de sorte à éviter, ou du moins à minimiser, la génération de contraintes mécaniques et de défauts cristallins dans le matériau semi-conducteur du substrat 10. En fait, la formation de la couche 14, par exemple en nitrure de silicium, sur le substrat 10 peut générer une déformation mécanique du substrat 10 et créer des dislocations dans le matériau cristallin de la face principale 11. Ainsi, l'épaisseur de la couche préliminaire 14' est dépendante de l'épaisseur de la couche 14 à déposer.

La couche préliminaire 14' permet avantageusement d'éviter la contamination de la surface active Sa disposée sur la face 11 du substrat 10 au cours du procédé de protection. De ce fait, la protection du bord du substrat 10 peut être avantageusement réalisée en respectant et en protégeant la surface principale du substrat (la première face 11). En outre, la couche préliminaire 14' peut servir également comme une couche d'arrêt de la gravure du premier matériau de protection, facilitant ainsi la réalisation du procédé de protection.

De manière avantageuse, la deuxième couche 15 est en oxyde de silicium, et le substrat 10 est préférentiellement à base de silicium. L'oxyde de silicium est avantageusement un matériau électriquement isolant compatible avec le silicium, et le nitrure de silicium. Préférentiellement, l'oxyde de silicium de la couche 15 est formée par oxydation, une technique facile à mettre en oeuvre, et qui permet d'obtenir un oxyde de silicium de très bonne qualité, notamment vis-à-vis d'une gravure chimique à base d'acide fluorhydrique.

Selon une alternative de réalisation, la deuxième couche de protection 15 peut être formée par un dépôt pleine plaque d'oxyde de silicium, réalisé par HTO ou TEOS. Le dépôt est alors suivi d'une étape d'aplanissement CMP ayant la couche de nitrure de silicium, *i.e.* la première couche de protection 14, comme couche d'arrêt.

En outre, un dépôt d'une couche en polysilicium (non représentée sur les figures) peut être réalisé sur la première couche de protection 14. La couche en polysilicium peut avoir une épaisseur allant de 5 à 200 nm. Une étape de d'aplanissement de la couche en polylisilicium avec arrêt sur la première couche 14 est ensuite effectuée. L'étape d'aplanissement est suivie d'une oxydation de la portion de la couche en polysilicium restant sur le bord 13 du substrat 10. Ce mode de réalisation peut être avantageusement utile lorsque le substrat 10 est à base de germanium.

Par ailleurs, dans le cas où le substrat 10 est à base d'un autre matériau semi-conducteur que le silicium, la deuxième couche de protection 15 est avantageusement à base d'un oxyde dudit matériau semi-conducteur du substrat 10. Par exemple, pour un substrat 10 à base de germanium ou d'arsenic, la couche de protection 15 peut être respectivement à base d'oxyde de germanium (GeO₂), ou d'un oxyde d'arsenic (AsO, As2O3, ...).

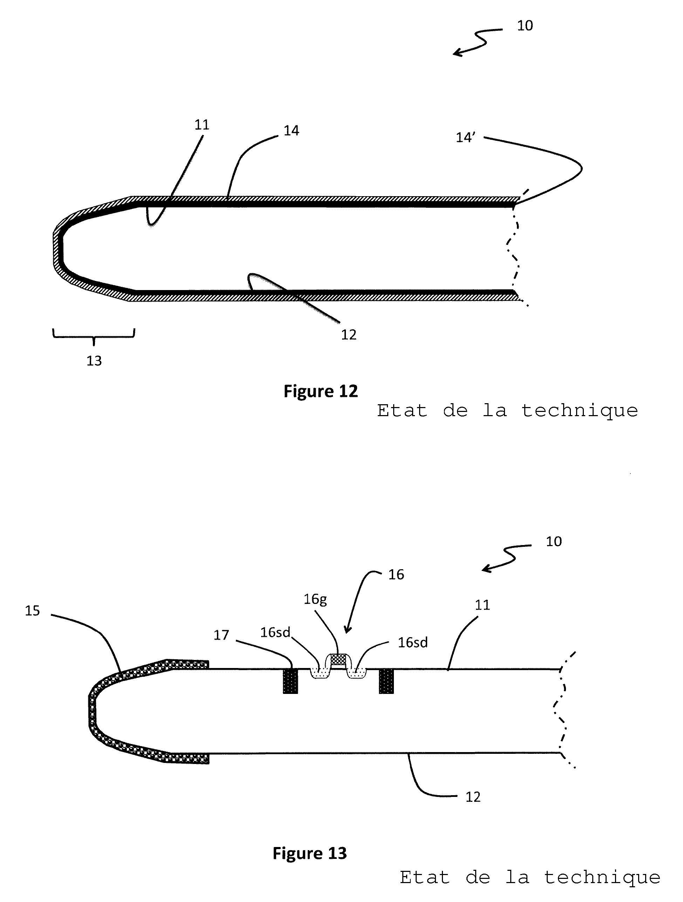

Selon la figure 13, un transistor à effet de champ 16 est réalisé sur la première face 11 principale du substrat 10, après la formation de la deuxième couche de protection 15, et l'élimination du premier matériau de protection. Le transistor à effet de champ 16 peut être réalisé selon un procédé classique.

Par exemple, après l'élimination de la couche préliminaire 14' et/ou l'élimination totale du premier matériau de protection, un empilement de grille 16g peut être formé sur un canal de conduction. L'empilement de grille 16g, peut comporter une couche de diélectrique de grille et une couche en matériau électriquement conducteur. Par ailleurs, le canal de conduction est défini de sorte à être disposé sur la face 11 du substrat 10, entre les régions source et drain 16sd. Ensuite, une étape d'implantation ionique peut être mise en oeuvre pour former dans le substrat 10 les régions source et drain 16sd. Des prises de contact en matériau électriquement conducteur sont alors formées sur l'empilement de grille 16g, et sur les régions source et drain 16sd. Selon un mode de réalisation plus avantageux, des isolations électriques de type STI, sont formées sur la face 11 du substrat 10, après l'élimination totale du premier matériau de protection et avant la formation du transistor à effet de champ 16.

Par ailleurs, l'épaisseur de la deuxième couche 15, est avantageusement ajustée de sorte à uniformiser la topologie générale de la première face 11 du substrat 10, pour notamment faciliter les étapes de CMP ultérieures. Ainsi, l'épaisseur de la couche 15 est ajustée en fonction de la profondeur des tranchées, de l'épaisseur d'oxyde de silicium déposé, et de la consommation du matériau sur le bord 13 du substrat 10. De manière avantageuse, l'épaisseur de la deuxième couche de protection 15 est déterminée de manière à minimiser la marche entre la face principale 11 et ladite couche 15. L'épaisseur de cette dernière est préférentiellement estimée à 2 fois l'épaisseur maximale de l'empilement de couches réalisé sur la première face 11 avant une première étape de CMP, plus une estimation de l'épaisseur du deuxième matériau de protection pouvant être consommé lors d'éventuelles étapes de nettoyage.

En outre, dans le cas d'un substrat de type SOI l'épaisseur de la couche électriquement isolante 10b est avantageusement prise en considération pour un ajustement efficace de l'épaisseur de la deuxième couche 15. Par exemple, pour des substrats SOI ayant une couche d'oxyde enterré (BOX) d'environ 145 nm d'épaisseur, destinés pour réaliser des transistors à effet de champ complétement déserté (FDSOI), l'épaisseur de la deuxième couche 15 en oxyde est préférentiellement de l'ordre de 460 nm. Cette épaisseur est avantageusement de l'ordre de 2 fois la somme des épaisseurs du BOX et de l'empilement de couches réalisé sur le film SOI. Cette épaisseur est estimée de sorte à faire correspondre le niveau du bord du substrat avec le sommet des grilles des transistors FDSOI recouvertes par une couche d'oxyde, permettant ainsi d'améliorer l'uniformité de la topologie globale de la première face 11 du substrat 10 lors d'une éventuelle étape de CMP.

Par ailleurs, la technique de formation de la deuxième couche 15 est avantageusement choisie en fonction de l'épaisseur visée. De manière préférentielle, la deuxième couche 15 en oxyde de silicium est réalisée par oxydation. Le type et la température d'oxydation seront choisis en fonction de l'épaisseur d'oxyde à former.

Selon un exemple préférentiel de réalisation :
- le substrat 10 est un substrat à base de silicium ;
- la couche préliminaire 14' est une couche mince en oxyde de silicium (SiO₂) ;
- la première couche de protection 14 est en nitrure de silicium (Si3N4) ; et
- la deuxième couche de protection 15 est en oxyde de silicium (SiO₂).

La couche préliminaire 14' en oxyde de silicium est formée sur le substrat 10 par oxydation, de préférence thermique soit en présence d'oxygène soit en présence de vapeur d'eau. Par ailleurs, l'épaisseur de la couche préliminaire 14' est dépendante de la première couche 14 en nitrure de silicium qu'on cherche à déposer. L'homme du métier est en mesure de choisir l'épaisseur de la couche préliminaire 14' en oxyde (communément appelée oxyde piédestal ou oxyde sacrificiel) nécessaire pour recevoir une première couche 14 en nitrure de silicium de sorte à ne pas générer des contraintes mécaniques et des dislocations dans le substrat 10.

Préférentiellement, la couche préliminaire 14' en oxyde de silicium a une épaisseur comprise entre 5 et 10 nm. Cette couche est destinée à recevoir une première couche 14 en nitrure de silicium ayant une épaisseur comprise entre 50 et 150 nm.

Selon cet exemple de réalisation, le nitrure de silicium de la couche de protection 14 est avantageusement déposé par LPCVD, pour garantir un masquage efficace lors de la formation de la deuxième couche 15 en oxyde de silicium. L'homme du métier est en mesure de déterminer l'épaisseur de la couche 14 en nitrure de silicium en fonction de l'épaisseur de la couche 15 à former sur le bord 13 du substrat 10. A titre d'exemple, pour une épaisseur d'environ 500 nm de la deuxième couche 15 en SiO₂, la couche 14 en Si₃N₄ peut avoir une épaisseur comprise entre 80 et 100 nm. Dans cet exemple de réalisation, la première couche de protection en Si₃N₄ à une épaisseur d'environ 80 nm.

Par ailleurs, le nitrure de silicium peut être déposé par PECVD (PECVD pour l'abréviation anglaise de « Plasma Enhanced Chemical Vapor Deposition). Ce type de dépôt peut être envisageable pour des épaisseurs de la couche 15 assez fines, par exemple comprises entre 10 et 50 nm.

La gravure du nitrure de silicium sur la zone périphérique Sp et sur le bord 13 du substrat 10 est avantageusement réalisée en utilisant une lithogravure. Ainsi, une couche usuelle en résine est étalée sur la première face 11 du substrat 10. L'épaisseur de la résine sera déterminée en fonction de l'épaisseur de la couche 14 en nitrure de silicium à graver. Par exemple, pour une couche en nitrure de silicium ayant une épaisseur de l'ordre de 80 à 100 nm, la couche en résine a préférentiellement une épaisseur comprise entre 100 et 200 nm.

Le détourage de la couche en résine est réalisé par voie chimique et/ou par voie optique. De manière avantageuse, une combinaison de ces deux types de détourage est utilisée, afin de garantir une élimination totale de la résine sur les zones du substrat 10 qu'on souhaite graver, surtout lorsque le substrat 10 est un substrat de type SOI comportant une ailette 10d.

Dans le cas d'un substrat 10 de type massif, la gravure de la première couche 14 est avantageusement une gravure physique en mode isotrope. Par ailleurs, une désoxydation par acide fluorhydrique (HF) dilué du substrat 10 est avantageusement réalisée, avant l'introduction du substrat 10 dans le réacteur de gravure. Le substrat 10 est disposé sur un support, qui est généralement un support à contact électrostatique. Le substrat 10 est disposé de sorte que la deuxième face 12 soit en contact avec ledit support. La première couche de protection 14 disposée sur la deuxième face 12 du substrat 10 est ainsi protégée et ne sera pas gravée. Les gaz N₂/CF₄/O₂ sont avantageusement utilisés dans le réacteur de gravure pour créer un plasma et pour graver le nitrure de silicium de manière isotrope. L'arrêt de gravure est réalisée, par exemple en détectant la couche préliminaire 14' en oxyde de silicium par luminescence du plasma. La gravure isotrope permet avantageusement d'éliminer le nitrure de silicium sur la totalité du bord 13, avec une très bonne sélectivité du nitrure de silicium par rapport à l'oxyde de silicium de l'ordre de 1 : 20.

En outre, une gravure en mode anisotrope peut également être réalisée pour éliminer le nitrure de silicium formé sur le substrat 10 de type massif. La couche préliminaire 14' en oxyde de silicium forme la couche d'arrêt de la gravure qui est réalisée en utilisant les gaz CF₂F₂/O₂/He pour former le plasma dans le réacteur de gravure. L'anisotropie de la gravure permet d'éliminer le nitrure de silicium sur le premier chanfrein (supérieur) 13a. Cependant, le nitrure de silicium sur la facette 13b et sur le deuxième chanfrein (inférieur) 13c peut ne pas être éliminé par la gravure anisotrope.

Dans le cas d'un substrat 10 de type SOI, plusieurs modes de gravure peuvent être utilisés. En effet, le substrat 10 SOI comporte une couche d'oxyde enterrée, qui peut servir également comme une couche d'arrêt de la gravure. En outre, le substrat 10 peut comporter une ailette 10d qui nécessite un traitement additionnel pour éliminer le nitrure de silicium localisé sous cette ailette. De manière avantageuse, la gravure du nitrure de silicium sur le substrat 10 de type SOI est réalisée de sorte à éliminer en outre la partie du film SOI formant l'ailette 10d.

Plusieurs gravures peuvent alors se suivre en changeant à chaque fois les conditions de l'arrêt de la gravure du nitrure de silicium et du silicium. Des gravures anisotropes peuvent être mises en oeuvre en utilisant les gaz CF₂F₂/O₂/He pour la formation du plasma. L'arrêt des gravures est réalisé en détectant le matériau de fin d'attaque par luminescence du plasma. Les gravures peuvent ainsi avoir comme couche d'arrêt, soit l'oxyde de silicium de la couche préliminaire 14', soit le silicium du substrat 10, soit l'oxyde enterré 10b. En outre, une sur-gravure isotrope peut être réalisée pour éliminer le nitrure de silicium disposé sous l'ailette 10d du substrat SOI 10.

Après l'étape de gravure, la couche de résine est éliminée, par exemple par un plasma formé à partir des gaz O₂/N₂. Le traitement par plasma est avantageusement suivi d'une gravure chimique humide à base de la solution SC1 à basse température (SC1 pour l'abréviation anglaise de « Standard Clean 1 »). Selon la couche d'arrêt utilisée dans l'étape de gravure du nitrure de silicium, la gravure chimique peut être sélective par rapport à l'oxyde de silicium de la couche préliminaire 14', ou par rapport au silicium du substrat 10, ou encore par rapport à l'oxyde de silicium de la couche enterrée 10b.

La couche 15 en oxyde de silicium est ensuite réalisée par oxydation, de préférence thermique, sur le bord 13 du substrat 10. En fonction de l'épaisseur d'oxyde recherchée, une oxydation thermique réalisée à une température allant de 700 à 1050 °C peut être mise en oeuvre. L'oxydation thermique peut également être une oxydation sèche en présence d'oxygène, ou humide en présence de vapeurs d'eau, etc. Le nitrure de silicium est ensuite éliminé de la surface du substrat 10 en utilisant une gravure humide classique à base d'acide ortho phosphorique (H₃PO₄).

## Revendications

1. Procédé de réalisation d'un substrat semi-conducteur sur isolant comportant les étapes suivantes :
fournir un substrat (10) à base d'un matériau semi-conducteur, le substrat (10) comportant des première (11) et deuxième (12) faces principales opposées reliées par une surface latérale (13), le substrat (10) comportant consécutivement :
- un support (10a) comprenant la deuxième face principale (12) ;
- une couche électriquement isolante (10b) ;
- une couche en matériau semi-conducteur (10c) comprenant la première face principale (11) ;
• former une première couche (14) en premier matériau de protection enrobant le substrat (10) ;
• graver le premier matériau de protection sur la surface latérale (13) en laissant un motif (11', 12') en premier matériau de protection recouvrant au moins partiellement chacune des première (11) et deuxième (12) faces ;
• former une deuxième couche (15) en deuxième matériau de protection sur la surface latérale (13) dépourvue du premier matériau de protection, le deuxième matériau de protection recouvrant la face latérale de la couche électriquement isolante (10b) ;
• éliminer le premier matériau de protection.

2. Procédé selon la revendication 1, **caractérisé en ce que** le premier matériau de protection est gravé en outre sur une zone périphérique (Sp) de la première face (11) adjacente à la surface latérale (13), et **en ce que** la deuxième couche (15) en deuxième matériau de protection est ensuite formée sur la surface latérale (13) et sur ladite zone périphérique (Sp).

3. Procédé selon l'une des revendications 1 et 2, **caractérisé en ce que** la première couche (14) est en nitrure de silicium.

4. Procédé selon la revendication 3, **caractérisé en ce que** la formation de la première couche (14) en premier matériau de protection est précédée de la formation d'une couche préliminaire (14') en oxyde de silicium enrobant le substrat (10).

5. Procédé selon l'une quelconque des revendications 1 à 4, **caractérisé en ce que** la deuxième couche (15) est en oxyde de silicium, formée par oxydation.

6. Procédé selon la revendication 2, **caractérisé en ce qu'**il comporte une étape de lithographie définissant la zone périphérique (Sp).

7. Procédé selon l'une quelconque des revendications 1 à 6, **caractérisé en ce qu'**après l'élimination du premier matériau de protection, un transistor à effet de champ (16) est réalisé sur la première face principale (11) du substrat (10).

## Patentansprüche

1. Verfahren zur Herstellung eines Halbleiter-auf Isolator-Substrats, welches folgende Verfahrensschritte umfasst:
- Herstellen eines Substrats (10) auf Basis eines Halbleiter-Materials, wobei das Substrat (10) eine erste Hauptseite (11) und eine zweite Hauptseite (12) aufweist, die einander gegenüber liegen und durch eine Seitenfläche (13) miteinander verbunden sind, wobei das Substrat (10) aufeinanderfolgend aufweist:
o einen Träger (10a) mit der zweiten Hauptseite (12),
o eine elektrisch isolierende Schicht (10b),
o eine Schicht aus Halbleiter-Material (10c) mit der ersten Hauptseite (11);
- Bilden einer ersten Schicht (14) aus einem ersten Schutzmaterial, die das Substrat (10) umhüllt,
- Ausstechen des Schutzmaterials auf der Seitenfläche (13) unter Hinterlassung eines Restbestandes (11', 12') aus erstem Schutzmaterial, der zumindest teilweise die erste und die zweite Hauptseite (11, 12) bedeckt,
- Bilden einer zweiten Schicht (15) aus einem zweiten Schutzmaterial auf der Seitenfläche (13), die nicht mit dem ersten Schutzmaterial versehen ist, wobei das zweite Schutzmaterial die Seitenfläche der elektrisch isolierenden Schicht (10b) bedeckt,
- Entfernen des ersten Schutzmaterials.

2. Verfahren nach Anspruch 1,
**dadurch gekennzeichnet,**
**dass** das erste Schutzmaterial ferner in einem Umfangsbereich (Sp) der ersten Seite (11), der an die Seitenfläche (13) angrenzt, ausgestochen wird, und dass die zweite Schicht (15) aus zweitem Schutzmaterial sodann auf der Seitenfläche (13) und dem genannten Umfangsbereich (Sp) gebildet wird.

3. Verfahren nach einem der Ansprüche 1 und 2,
**dadurch gekennzeichnet,**
**dass** die erste Schicht (14) aus Siliciumnitrid besteht.

4. Verfahren nach Anspruch 3,
**dadurch gekennzeichnet,**
**dass** dem Bilden der ersten Schicht (14) aus erstem Schutzmaterial die Bildung einer Vorab-Schicht (14') aus Siliciumoxid vorausgeht, welche das Substrat (10) umhüllt.

5. Verfahren nach einem der Ansprüche 1 bis 4,
**dadurch gekennzeichnet,**
**dass** die zweite Schicht (15) aus Siliciumoxid besteht, das durch Oxidation gebildet wird.

6. Verfahren nach Anspruch 2,
**dadurch gekennzeichnet,**
**dass** es einen Verfahrensschritt des Lithographierens umfasst, wodurch der Umfangsbereich (Sp) gebildet wird.

7. Verfahren nach einem der Ansprüche 1 bis 6,
**dadurch gekennzeichnet,**
**dass** nach dem Entfernen des ersten Schutzmaterials ein Feldeffekttransistor (16) auf der ersten Hauptseite (11) des Substrats (10) hergestellt wird.

## Claims

1. A method for producing a semiconductor on insulator substrate comprising the following steps:
• providing a substrate (10) having a semiconductor material base, the substrate (10) comprising opposite first (11) and second (12) main surfaces joined by a lateral surface (13), the substrate (10) further consecutively comprising:
- a support (10a) comprising the second main surface (12);
- an electrically insulating layer (10b);
- a layer made from semiconductor material (10c) comprising the first main surface (11);
• forming a first layer (14) made from first protective material, coating the substrate (10);
• etching the first protective material on the lateral surface (13) leaving a pattern (11, 11') of first protection material at least partially covering the first (11) and second (12) main surfaces;
• forming a second layer (15) made from second protective material on the lateral surface (13) devoid of the first protective material, the second protective material covering the lateral surface of the electrically insulating layer (10b);
• eliminating the first protective material.

2. The method according to claim 1, **characterized in that** the first protective material is further etched on a peripheral area (Sp) of the first main surface (11), the peripheral area (Sp) being adjacent to the lateral surface (13), and **in that** the second layer (15) of second protective material is then formed on the lateral surface (13) and on said peripheral area (Sp).

3. The method according to one of claims 1 and 2, **characterized in that** the first layer (14) is made from silicon nitride.

4. The method according to claim 3, **characterized in that** the formation of the first layer (14) made from the first protective material is preceded by formation of a preliminary layer (14') of silicon oxide coating the substrate (10).

5. The method according to one of claims 1 and 4, **characterized in that** the second layer (15) is made from silicon oxide, formed by oxidation.

6. The method according to claim 2, **characterized in that** the method comprises a lithography step defining the peripheral area (Sp).

7. The method according to one of claims 1 and 6, **characterized in that** after elimination of the first protective material, a field effect transistor (16) is produced on the first main surface (11) of the substrate (10).
